# EUROPEAN PATENT SPECIFICATION

(11) **EP 1 942 467 B1**
(45) Date of publication and mention of the grant of the patent: **12.06.2013**
(21) Application number: 07122999.1
(22) Date of filing: 12.12.2007
(51) Int. Cl.: G07C 9/00, B60R 25/04, H03K 17/94

(54) **Sensor for vehicle handles**
Sensor für Fahrzeuggriffe
Capteur pour poignées de véhicule

(30) Priority: 28.12.2006 IT MI20062529
(43) Date of publication of application: 09.07.2008
(73) Proprietor: Valeo S.p.A., Santena (TO) (IT)
(72) Inventor: Lesueur, Guillaume, San Mauro Torinese TO 10099 (IT); Savant, Fiorenzo, Collegno TO 10093 (IT)
(74) Representative: Larger, Solène

(56) References cited:
- WO-A1-02/02893
- WO-A1-2004/007879
- FR-A1- 2 799 491
- US-B1- 6 462 291

## Description

The present invention relates to a sensor, and in particular to a sensor which can be applied to a handle of a door of a motor vehicle for improving its working.

Document WO 02/02893 discloses an optical sensor for a handle having a housing made of an inner portion and an outer portion.

EP-A-972897 discloses a sensor for vehicle handles, which comprises a container for a transmitter and a receiver of electromagnetic signals. Said container comprises an inner portion which encloses the transmitter and the receiver, as well as an outer portion provided with a window for the transmission of the electromagnetic signals from and/or to the outside of the container. The inner portion of the container has different shape and size with respect to the outer portion, so that an elastomeric gasket must be arranged between the two portions for avoiding water leaks into the container.

However, in extreme situations and/or temperatures, the seal of said gasket is not always perfect, with a consequent risk of malfunctions of the sensor.

It is therefore an object of the present invention to provide a sensor which is free from said disadvantage. Said object is achieved with a sensor, whose main features are disclosed in the first claim and other features are disclosed in the subsequent claims.

Thanks to the flanges and to the particular shape of the portions of the container, the latter can be easily sealed by means of a ultrasonic welding or a hot welding, so as to prevent water leaks through the interface between the two portions.

Furthermore, the outer portion of the container is preferably made of a single piece of a transparent plastic material with the window and with one or more lenses for converging the electromagnetic signals, so as to prevent any leak and to reduce the manufacturing costs and times.

According to a particular aspect of the invention, the container is provided with an opening closed by a semipermeable membrane, for compensating possible differences of the air pressure inside and outside the container, due for example to temperature variations, so as to prevent any tension on the welding between the flanges of the container portions.

The seal of the sensor according to the present invention is preferably increased by a particular elastomeric gasket which surrounds the window and is pressed by an outer frame.

Further advantages and features of the sensor according to the present invention will become evident to those skilled in the art from the following detailed and nonlimiting description of an embodiment thereof with reference to the attached drawings, wherein:
- figure 1 shows an exploded side view of the sensor;
- figure 2 shows a front view of the sensor of figure 1;
- figure 3 shows a side view of the sensor of figure 1; and
- figure 4 shows a rear view of the sensor of figure 1.

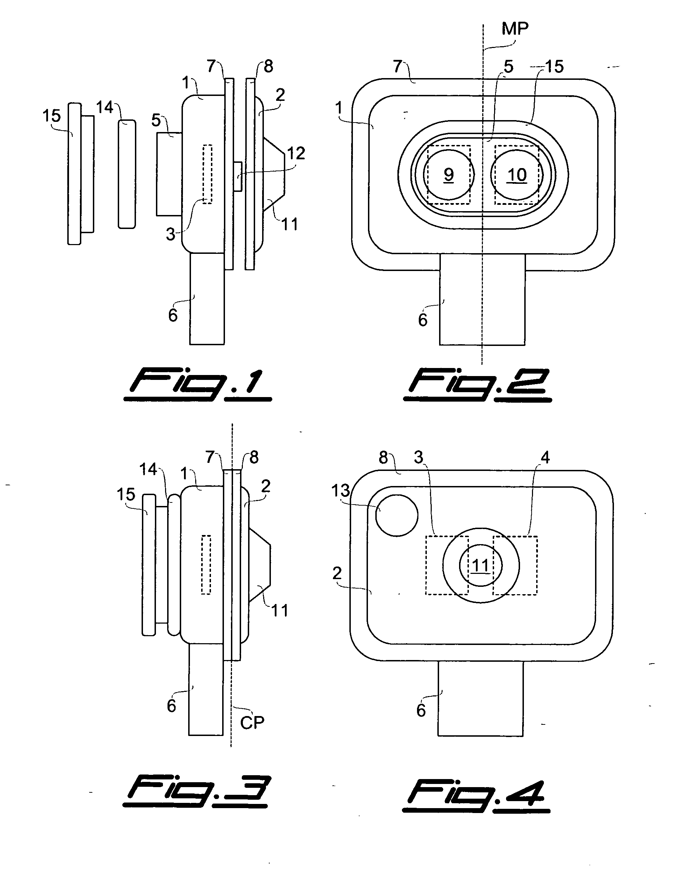

Referring to figures 1 to 4, it is seen that the sensor according to the present invention comprises in a known way at least one outer portion 1 and one inner portion 2 of a container suitable for enclosing a transmitter 3 and/or a receiver 4 (shown with broken lines) of electromagnetic signals, for example optical signals (infrared). The outer portion 1 of the container is provided with at least one window 5 for the transmission of the electromagnetic signals from and/or to the outside of the container, in particular from and/or to the lever (not shown in the figure) of a vehicle handle. A portion of the container, preferably the outer portion 1, is provided with a transversal extension 6 suitable for containing electric connectors and/or conductors for the connection of the sensor to control devices (not shown in the figures).

According to the invention, the edge of the outer portion 1 of the container turned toward the inner portion 2 is provided with a first flange 7 suitable for being joined to a second flange 8 which surrounds the edge of the inner portion 2 turned toward the outer portion 1 of the container. The first flange 7 is joined to the second flange 8 by means of a ultrasonic welding or by means of a hot welding.. The contact plane CP passing between the adjacent surfaces of flanges 7 and 8 does not cross the transversal extension 6, so as to facilitate their welding with a hot blade. The outer portion 1, the inner portion 2, window 5 and the transversal extension 6 are preferably symmetric with respect to a median plane MP, so that the sensor can be mounted both on the left side and on the right side of a motor vehicle.

The outer portion 1 and/or the inner portion 2 of the container have a substantially parallelepiped shape with rounded edges, while the first flange 7 and/or the second flange 8 have a same substantially rectangular shape with rounded corners. The outer portion 1 is made of a single piece of a transparent plastic material, in particular polycarbonate, with window 5. One or more lenses 9, 10 are in turn made of a single piece of a transparent plastic material, in particular polycarbonate, with window 5 and are aligned with transmitter 3 and/or receiver 4, respectively, for converging the electromagnetic signals. The outer portion 1 and/or the inner portion 2 of the container can further be made of a single piece with other parts of the handle comprising the sensor according to the present invention. The inner portion 2 of the container is provided with an elastomeric cap 11, substantially frustoconical-shaped, which protrudes outside the inner portion 2 and is arranged in correspondence with a push-button 12 suitable for being enclosed in the container for manually operating the sensor. The container is further provided with an opening, preferably made in its inner portion 2, which is closed by a semipermeable membrane 13, i.e. a membrane permeable to gases but impermeable to liquids. Window 5 protrudes outside the container and is surrounded by an elastomeric gasket 14 suitable for being pressed by a frame 15 of a covering which is applied outside the handle and surrounds at least partially window 5, so that the elastomeric gasket 14 seals the gap between window 5 and frame 15.

Possible variations and/or additions may be made by those skilled in the art to the hereinabove disclosed and illustrated embodiment of the invention while remaining within the scope of the following claims.

## Claims

1. Sensor for vehicle handles, which comprises at least one outer portion (1) and one inner portion (2) of a container suitable for enclosing a transmitter (3) and/or a receiver (4) of electromagnetic signals, wherein the outer portion (1) of the container is provided with at least one window (5) for the transmission of the electromagnetic signals from and/or to the outside of the container, the edge of the outer portion (1) of the container turned toward the inner portion (2) being provided with a first flange (7) suitable for being joined to a second flange (8) which surrounds the edge of the inner portion (2) turned toward the outer portion (1) of the container, **characterized in that** each of the first and second Flanges (7,8) outward from the interiors of the inner and outer portions (1,2), once the said flanges (7,8) are joined together, and
**in that** the first flange (7) is joined to the second flange (8) by means of a ultrasonic welding or by means of a hot welding.

2. Sensor according to one of the previous claims, **characterized in that** the outer portion (1) of the container is provided with a transversal extension (6) suitable for containing electric connectors and/or conductors for the connection of the sensor to control devices.

3. Sensor according to the previous claim, **characterized in that** the contact plane (CP) passing between the adjacent surfaces of the flanges (7, 8) does not cross the transversal extension (6).

4. Sensor according to claim 2 or 3, **characterized in that** the outer portion (1), the inner portion (2), the window (5) and the transversal extension (6) are symmetric with respect to a median plane (MP).

5. Sensor according to one of the previous claims, **characterized in that** the outer portion (1) and/or the inner portion (2) of the container have a substantially parallelepiped shape with rounded edges.

6. Sensor according to one of the previous claims, **characterized in that** the first flange (7) and the second flange (8) have the same shape.

7. Sensor according to one of the previous claims, **characterized in that** the first flange (7) and/or the second flange (8) have a substantially rectangular shape with rounded corners.

8. Sensor according to one of the previous claims, **characterized in that** the outer portion (1) of the container is made of a single piece of a transparent plastic material, in particular polycarbonate, with the window (5).

9. Sensor according to one of the previous claims, **characterized in that** one or more lenses (9, 10) are made of a single piece of a transparent plastic material, in particular polycarbonate, with the window (5).

10. Sensor according to one of the previous claims, **characterized in that** the container is provided with an elastomeric cap (11), which is arranged in correspondence with a push-button (12) suitable for being enclosed in the container for manually operating the sensor.

11. Sensor according to the previous claim, **characterized in that** said elastomeric cap (11) protrudes outside the outer portion (2) of the container.

12. Sensor according to one of the previous claims, **characterized in that** the container is provided with an opening closed by a semipermeable membrane (13).

13. Sensor according to the previous claim, **characterized in that** said opening is made in the inner portion (2) of the container.

14. Sensor according to one of the previous claims, **characterized in that** the window (5) pmtrudes outside the container and is surrounded by an elastomeric gasket (14).

15. Sensor according to the previous claim, **characterized in that** said elastomeric gasket (14) is pressed by a frame (15) which surrounds at least partially the window (5), so that the elastomeric gasket (14) seals the gap between the window (5) and the frame (15).

## Patentansprüche

1. Sensor für Fahrzeuggriffe, der mindestens einen Außenabschnitt (1) und einen Innenabschnitt (2) eines Behälters umfasst, der sich zum Einschließen eines Senders (3) und/oder eines Empfängers (4) von elektromagnetischen Signalen eignet, wobei der Außenabschnitt (1) des Behälters mit mindestens einem Fenster (5) für die Übertragung der elektromagnetischen Signale von der und/oder zu der Außenseite des Behälters ausgestattet ist, wobei die dem Innenabschnitt (2) zugewandte Kante des Außenabschnitts (1) des Behälters mit einem ersten Flansch (7) ausgestattet ist, der sich dafür eignet, mit einem zweiten Flansch (8) gefügt zu werden, der die dem Außenabschnitt (1) des Behälters zugewandte Kante des Innenabschnitts (2) umgibt, **dadurch gekennzeichnet, dass** sich jeder des ersten und zweiten Flansches (7, 8) von dem Inneren des Innen- und Außenabschnitts (1, 2) nach außen erstreckt, nachdem die Flansche (7, 8) miteinander gefügt sind, und dass der erste Flansch (7) mit Hilfe von Ultraschallschweißen oder mit Hilfe von Heißschweißen mit dem zweiten Flansch (8) gefügt wird.

2. Sensor nach Anspruch 1, **dadurch gekennzeichnet, dass** der Außenabschnitt (1) des Behälters mit einer Quererstreckung (6) ausgestattet ist, die sich dafür eignet, elektrische Verbinder und/oder Leiter für die Verbindung des Sensors mit Steuereinrichtungen zu enthalten.

3. Sensor nach dem vorhergehenden Anspruch, **dadurch gekennzeichnet, dass** die zwischen den benachbarten Oberflächen der Flansche (7, 8) verlaufende Kontaktebene (CP) die Quererstreckung (6) nicht kreuzt.

4. Sensor nach Anspruch 2 oder 3, **dadurch gekennzeichnet, dass** der Außenabschnitt (1), der Innenabschnitt (2), das Fenster (5) und die Quererstreckung (6) bezüglich einer Mittelebene (MP) symmetrisch sind.

5. Sensor nach einem der vorhergehenden Ansprüche, **dadurch gekennzeichnet, dass** der Außenabschnitt (1) und/oder der Innenabschnitt (2) des Behälters im Wesentlichen eine Quaderform mit abgerundeten Kanten besitzen.

6. Sensor nach einem der vorhergehenden Ansprüche, **dadurch gekennzeichnet, dass** der erste Flansch (7) und der zweite Flansch (8) die gleiche Gestalt aufweisen.

7. Sensor nach einem der vorhergehenden Ansprüche, **dadurch gekennzeichnet, dass** der erste Flansch (7) und/oder der zweite Flansch (8) eine im Wesentlichen rechteckige Gestalt mit abgerundeten Ecken aufweisen.

8. Sensor nach einem der vorhergehenden Ansprüche, **dadurch gekennzeichnet, dass** der Außenabschnitt (1) des Behälters aus einem einzelnen Stück aus transparentem Kunststoffmaterial, insbesondere Polycarbonat, mit dem Fenster (5) hergestellt ist.

9. Sensor nach einem der vorhergehenden Ansprüche, **dadurch gekennzeichnet, dass** eine oder mehrere Linsen (9, 10) aus einem einzelnen Stück aus transparentem Kunststoffmaterial, insbesondere Polycarbonat, mit dem Fenster (5) hergestellt sind.

10. Sensor nach einem der vorhergehenden Ansprüche, **dadurch gekennzeichnet, dass** der Behälter mit einer elastomeren Kappe (11) ausgestattet ist, die in Übereinstimmung mit einem Druckknopf (12) ausgelegt ist, dazu geeignet, in dem Behälter eingeschlossen zu werden, um den Sensor manuell zu betätigen.

11. Sensor nach dem vorhergehenden Anspruch, **dadurch gekennzeichnet, dass** die elastomere Kappe (11) außerhalb des Innenabschnitts (2) des Behälters vorsteht.

12. Sensor nach einem der vorhergehenden Ansprüche, **dadurch gekennzeichnet, dass** der Behälter mit einer Öffnung ausgestattet ist, die durch eine halbdurchlässige Membran (13) verschlossen ist.

13. Sensor nach dem vorhergehenden Anspruch, **dadurch gekennzeichnet, dass** die Öffnung in dem Innenabschnitt (2) des Behälters ausgebildet ist.

14. Sensor nach einem der vorhergehenden Ansprüche, **dadurch gekennzeichnet, dass** das Fenster (5) außerhalb des Behälters vorsteht und von einer elastomeren Dichtung (14) umgeben ist.

15. Sensor nach dem vorhergehenden Anspruch, **dadurch gekennzeichnet, dass** die elastomere Dichtung (14) durch einen Rahmen (15), der das Fenster (5) mindestens teilweise umgibt, so gedrückt wird, dass die elastomere Dichtung (14) den Spalt zwischen dem Fenster (5) und dem Rahmen (15) abdichtet.

## Revendications

1. Capteur pour poignées de véhicule, comportant au moins une partie extérieure (1) et une partie intérieure (2) d'un récipient apte à renfermer un émetteur (3) et / ou un récepteur (4) de signaux électromagnétique, la partie extérieure (1) du récipient étant munie d'au moins une fenêtre (5) servant à l'émission des signaux électromagnétiques à partir de et / ou vers l'extérieur du récipient, le bord de la partie extérieure (1) du récipient tourné vers la partie intérieure (2) étant muni d'un premier flasque (7) apte à être joint à un deuxième flasque (8) entourant le bord de la partie intérieure (2) tourné vers la partie extérieure (1) du récipient, **caractérisé en ce que** chacun des premier et deuxième flasques (7, 8) s'étend vers l'extérieur à partir des intérieurs des parties intérieure et extérieure (1, 2) une fois que lesdits flasques (7, 8) sont joints ensemble, et **en ce que** le premier flasque (7) est joint au deuxième flasque (8) au moyen d'une soudure ultrasonique ou au moyen d'une soudure à chaud.

2. Capteur selon la revendication 1, **caractérisé en ce que** la partie extérieure (1) du récipient est munie d'un prolongement transversal (6) apte à contenir des connecteurs et / ou des conducteurs électriques servant à relier le capteur à des dispositifs de commande.

3. Capteur selon la revendication précédente, **caractérisé en ce que** le plan de contact (CP) passant entre les surfaces adjacentes des flasques (7, 8) ne croise pas le prolongement transversal (6).

4. Capteur selon la revendication 2 ou 3, **caractérisé en ce que** la partie extérieure (1), la partie intérieure (2), la fenêtre (5) et le prolongement transversal (6) sont symétriques par rapport à un plan médian (MP).

5. Capteur selon l'une des revendications précédentes, **caractérisé en ce que** la partie extérieure (1) et / ou la partie intérieure (2) du récipient présentent une forme sensiblement parallélépipédique avec des arêtes arrondies.

6. Capteur selon l'une des revendications précédentes, **caractérisé en ce que** le premier flasque (7) et le deuxième flasque (8) présentent la même forme.

7. Capteur selon l'une des revendications précédentes, **caractérisé en ce que** le premier flasque (7) et / ou le deuxième flasque (8) présentent une forme sensiblement rectangulaire avec des coins arrondis.

8. Capteur selon l'une des revendications précédentes, **caractérisé en ce que** la partie extérieure (1) du récipient est constituée d'une seule pièce d'une matière plastique transparente, en particulier du polycarbonate, conjointement à la fenêtre (5).

9. Capteur selon l'une des revendications précédentes, **caractérisé en ce qu'**une ou plusieurs lentilles (9, 10) sont constituées d'une seule pièce d'une matière plastique transparente, en particulier du polycarbonate, conjointement à la fenêtre (5).

10. Capteur selon l'une des revendications précédentes, **caractérisé en ce que** le récipient est muni d'un capuchon élastomérique (11), qui est disposé en correspondance avec un bouton-poussoir (12) apte à être enfermé dans le récipient pour actionner manuellement le capteur.

11. Capteur selon la revendication précédente, **caractérisé en ce que** ledit capuchon élastomérique (11) dépasse à l'extérieur de la partie intérieure (2) du récipient.

12. Capteur selon l'une des revendications précédentes, **caractérisé en ce que** le récipient est muni d'une ouverture obturée par une membrane semi-perméable (13).

13. Capteur selon la revendication précédente, **caractérisé en ce que** ladite ouverture est pratiquée dans la partie intérieure (2) du récipient.

14. Capteur selon l'une des revendications précédentes, **caractérisé en ce que** la fenêtre (5) dépasse à l'extérieur du récipient et est entourée par un joint élastomérique (14).

15. Capteur selon la revendication précédente, **caractérisé en ce que** ledit joint élastomérique (14) est pressé par un cadre (15) qui entoure au moins partiellement la fenêtre (5), de telle sorte que le joint élastomérique (14) bouche l'interstice entre la fenêtre (5) et le cadre (15).
